# EUROPÄISCHE PATENTANMELDUNG

(11) **EP 1 889 943 A1**
(43) Veröffentlichungstag der Anmeldung: **20.02.2008**
(21) Anmeldenummer: 07112248.5
(22) Anmeldetag: 11.07.2007
(51) Int. Cl.: C23C 16/00, C23C 16/453, C23C 16/455, C23C 16/04, C23C 16/20, C23C 16/44

(54) **Verfahren und Vorrichtung zum Beschichten eines Grundkörpers**

(30) Priorität: 08.08.2006 EP 06118585
(71) Anmelder: Sulzer Metco AG, 5610 Wohlen (CH)
(72) Erfinder: Beele, Dr. Wolfram, 5212 Hausen (CH); Loch, Dr. Michael, 79664 Wehr (DE); Pochet, Louis F., Greensburg, PA 15601 (US); Meyer, Beat, 5611 Anglikon (CH)
(74) Vertreter: Sulzer Management AG

(57) **Zusammenfassung**

Es wird Verfahren vorgeschlagen zum Beschichten eines Grundkörpers, der mindestens einen inneren Kanal (101,102) aufweist, bei welchem Verfahren das Beschichten mittels chemischer Abscheidung aus der Dampfphase erfolgt, wobei der Grundkörper (10) auf einer HaHeeinrichtung (3) in einem Reaktionsraum (21) eines Reaktorgefässes (2) angeordnet wird, wobei von einer externen Quelle (7) ein Prozessgas geliefert wird, das Prozessgas einem internen Generator (4) in dem Reaktionsgefäss (2) zugeführt wird, in welchem die Reaktivität des Prozessgases mit Hilfe eines reaktivitätsändernden Materials erhöht wird, und das Prozessgas aus dem internen Generator (4) in den Reaktionsraum (21) geleitet wird. Das Prozessgas wird aus dem Reaktionsraum (21) durch den mindestens einen inneren Kanal (101,102) und durch die Halteeinrichtung (3) zu einem Auslass (5) des Reaktorgefässes (2) gesaugt. Ferner wird eine für das Verfahren geeignete Vorrichtung vorgeschlagen.

## Beschreibung

Die Erfindung betrifft ein Verfahren und eine Vorrichtung zum Beschichten eines Grundkörpers, der mindestens einen inneren Kanal aufweist, wobei das Beschichten mittels chemischer Abscheidung aus der Dampfphase erfolgt, gemäss dem Oberbegriff des unabhängigen Anspruchs der jeweiligen Kategorie,

Im Speziellen betrifft die Erfindung ein Verfahren und eine Vorrichtung, die dazu geeignet sind, Grundkörper mit komplexen inneren Strukturen, insbesondere Turbinenschaufeln mit Kühlkanälen, mit einer vorzugsweise metallischen Beschichtung zu versehen.

Beim Betrieb von Turbinen, die beispielsweise als Triebwerke für Flugzeuge oder als landgestützte industrielle Gasturbinen eingesetzt werden, wird es angestrebt, eine möglichst hohe Temperatur des durch die Verbrennung entstehenden Gases zu realisieren, weil die Effizienz der Turbine umso besser wird je höher die Temperatur des Gases ist. Daher ist es vor allem im Hochtemperaturbereich der Turbine üblich, zum einen als Werkstoff metallische Verbindungen zu wählen, die auch bei sehr hohen Temperaturen noch sehr gute mechanische Eigenschaften besitzen und zum anderen, die Werkstücke, wie z.B. die Turbinenschaufeln, aktiv durch innere Kühlkanäle zu kühlen und/oder mit Schutzschichten zu versehen,

Als Material für die thermisch am meisten belasteten Werkstücke der Turbine werden in der Regel Superlegierungen, welche üblicherweise Nickel- oder Kobaltbasislegierungen sind, verwendet. Diese Superlegierungen weisen zwar eine ausserordentliche Festigkeit bei sehr hohen Temperaturen auf, ihre Eigenschaften bezüglich Oxidationsbeständigkeit und Heisskorrosionsbeständigkeit in der aggressiven Atomsphäre der Turbine sind jedoch häufig nicht ausreichend. Um dieses Problem zu lösen, ist es bekannt, die Superlegierungen mit einer Schicht zu versehen, die eine sehr gute Oxidations- und Heisskorrosionsbeständigkeit aufweist.

Zur Erzeugung heisskorrosions- bzw. heissoxidationsbestänäiger Schichten auf Grundkörpern aus Superlegierungen ist es beispielsweise bekannt, vorzugsweise metallische Beschichtungen, insbesondere Aluminide zu verwenden. Hierzu ist eine Alitierung (Aluminisierung) der inneren und äusseren Oberflächen des Grundkörpers notwendig,

Vor allem die Beschichtung der inneren Oberflächen bzw. der inneren Kühlkanäle ist jedoch nicht einfach. In Turbinenschaufeln sind die inneren Strukturen sehr komplex und Üblicherweise nur durch sehr enge Kanäle zugänglich. Andererseits ist bei den extrem hohen Temperaturen eine Beschichtung der inneren Kanäle notwendig, weil diese sonst im Betrieb rasch oxidiert werden. Da die Oxide in den engen gewundenen Kanälen entstehen, verringern sie als Ablagerungen den Strömungsquerschnitt für das Kühlmedium, wodurch sich die Effizienz der Kühlung verschlechtert. Hieraus resultiert ein sich aufschaukelnder Degradationsprozess.

Zur Beschichtung, insbesondere zur Alitierung solcher innerer Kanäle und Passagen, sind einige Verfahren bekannt, die jedoch Nachteile aufweisen.

Ein bekanntes Verfahren ist die Packzementierung, bei welcher die zu beschichtenden Oberflächen in ein feines Pulver eingebettet werden, das eine Aluminiumquelle beinhaltet sowie ein flüchtiges Halogenid als chemisches Transfermedium, Der Diffusionsprozess findet üblicherweise bei Temperaturen von mindestens 700°C statt. Der Nachteil an diesem Prozess ist, dass das Pulver teilweise die Kanäle oder Öffnungen zusetzen kann, sodass später die zum Betrieb der Turbinenschaufel notwendige Kühlluft nicht mehr oder unzulänglich durchströmen kann.

Ein anderes Verfahren, das beispielsweise in der US-A-4,132,816 beschrieben wird, ist unter der Bezeichnung "over the pack process" bekannt geworden. Hierbei werden die zu beschichtenden Teile nicht mehr in das Pulver eingebettet sondern über dem Pulver aufgehängt. Auch wenn dieses Verfahren durch Vermeiden des Kontakts zwischen Pulver und zu beschichtendem Teil ein Blockieren der Kanäle vermeidet, beobachtet man hier, dass die Beschichtungsdicke an den Eingängen der Kanäle grösser ist und dann rapide mit zunehmender Entfernung vom Eingang abnimmt. Zudem kann das Verhältnis der Beschichtungsdicke und Konzentration auf den Aussenflächen gegenüber den inneren Kanälen nur schwer oder gar nicht kontrolliert werden. Solche ungleichmässigen Beschichtungen können die Turbinenschaufeln sogar unbrauchbar machen.

Gemäss einer Modifizierung des Verfahrens, die in der US-A-4,148,275 beschrieben wird, sind zwei Kammern in dem Reaktor vorgesehen, um gleichzeitig die inneren und die äusseren Oberflächen zu beschichten. Auch hier ist die Kontrolle und die Reproduzierbarkeit der Schichtdicke problematisch.

Eine andere Methode speziell zum Beschichten innerer Kanäle ist die chemische Abscheidung aus der Dampf- oder Gasphase (chemical vapor deposition: CVP), wie sie beispielsweise in der US-A-5,264,245 beschrieben wird. Der zu beschichtende Grundkörper wird in ein Reaktorgefäss platziert. Ein aluminiumhaltiges Gas wird ausserhalb des Reaktorgefässes erzeugt, üblicherweise, indem festes Aluminium mit einem Aktivatorgas, in der Regel ein Halogenid, zur Reaktion gebracht wird. Das Aluminiumhalogenidgas wird zu dem Reaktorgefäss transportiert und im Reaktorgefäss bezüglich seiner Reaktivität verbessert. Beispielsweise wird aus Aluminiumtrichlorid durch geeignete Medien das weniger stabile Aluminiummonochlorid generiert, das einen höheren relativen Aluminiumanteil aufweist und reaktiver ist. Dieses Gas wird dann mit den inneren und äusseren Oberflächen des Grundkörpers in Kontakt gebracht, wodurch die Alitierung erfolgt. Zur Beschichtung der inneren Oberflächen ist ein separater Gaseinlass vorgesehen durch welchen das Gas unmittelbar in die inneren Kanäle der Grundkörper gelangt und durch diese in den Reaktorraum gedrückt wird, aus dem es dann abgesaugt wird.

Aber auch dieses Verfahren ist bezüglich der Gleichmässigkeit der Beschichtung, insbesondere der inneren Kanäle, noch nicht befriedigend.

Ausgehend von diesem Stand der Technik, ist es eine Aufgabe der Erfindung, ein Verfahren und eine Vorrichtung vorzuschlagen zum Beschichten eines Grundkörpers, der mindestens einen inneren Kanal aufweist, wobei eine möglichst gleichmässige Beschichtung insbesondere der inneren Oberflächen bzw. der inneren Kanäle ermöglicht werden soll.

Die diese Aufgabe in verfahrenstechnischer und apparativer Hinsicht lösenden Gegenstände der Erfindung sind durch die Merkmale der unabhängigen Ansprüche der jeweiligen Kategorie gekennzeichnet.

Erfindungsgemäss wird also ein Verfahren vorgeschlagen zum Beschichten eines Grundkörpers, der mindestens einen inneren Kanal aufweist, bei welchem Verfahren das Beschichten mittels chemischer Abscheidung aus der Dampfphase erfolgt, wobei der Grundkörper auf einer Halteeinrichtung in einem Reaktionsraum eines Reaktorgefässes angeordnet wird, wobei von einer externen Quelle ein Prozessgas geliefert wird, das Prozessgas einem internen Generator in dem Reaktionsgefäss zugeführt wird, in welchem die Reaktivität des Prozessgases mit Hilfe eines reaktivitätsändernden Materials erhöht wird, und das Prozessgas aus dem internen Generator in den Reaktionsraum geleitet wird. Das Prozessgas wird aus dem Reaktionsraum durch den mindestens einen inneren Kanal und durch die Halteeinrichtung zu einem Auslass des Reaktorgefässes gesaugt.

Überraschenderweise hat sich gezeigt, dass sich durch die Massnahme, das Prozessgas für die Beschichtung der inneren Oberflächen zunächst in den Reaktionsraum einzubringen und dann aus diesem durch den mindestens einen inneren Kanal abzusaugen, insbesondere die inneren Oberflächen wesentlich gleichmässiger und effizienter beschichten lassen.

Vorzugsweise wird die Flussrate des Prozessgases durch jeden inneren Kanal durch die Geometrie der Strömungsverbindung zwischen dem inneren Kanal und der Halteeinrichtung kontrolliert. Dazu sind die Halteeinrichtungen so ausgestaltet, dass sie Öffnungen aufweisen, die in Strömungsverbindung mit einem inneren Kanal stehen. Werden diese Öffnungen kleiner oder grösser gestaltet, so lässt sich damit die Flussrate des Prozessgases - und folglich die Verweilzeit des Prozossgases in dem inneren Kanal kontrolliert einstellen. Insbesondere wenn mehrere Kanäle unterschiedlicher Abmessungen (wie Länge, Durchmesser, Krümmung usw.) in dem Grundkörper vorgesehen sind, lassen sich durch diese Massnahme die relativen Flussraten in den verschiedenen Kanälen gezielt und kontrolliert beeinflussen. So können beispielsweise in der Halteeinrichtung Drosselstellen vorgesehen sein, um die Flussraten durch Kanäle unterschiedlichen Durchmessers so einzustellen, dass die gleichen Verweilzeiten des Prozessgases in den jeweiligen Kanälen resultieren.

Eine weitere vorteilhafte Massnahme besteht darin, dass der Reaktionsraum vor dem Beschichten mindestens einmal mit Helium gefüllt und evakuiert wird. Hierdurch lassen sich störende Reste von Luft, die bei der Beschichtung zu ungewünschter Oxidation führen würde, wirkungsvoll aus dem Reaktionsraum entfernen,

Gemäss einer bevorzugten Verfahrensführung ist das Beschichten ein Aluminiumbeschichten.

Vorzugsweise ist das reaktivitätsändernde Material flüssig ist und insbesondere flüssiges Aluminium, Es hat sich gezeigt, dass mit flüssigem Material, insbesondere flüssigem Aluminium eine deutlich höhere Konzentration des abzuscheidenden Materials im Prozessgas erzeugt werden kann, was eine effektivere Beschichtung ermöglicht

Der Grundkörper kann insbesondere eine Turbinenschaufel ist, das heisst, das erfindungsgemässe Verfahren ist speziell für das Beschichten der äusseren und inneren Oberflächen von Turbinenschaufeln geeignet.

Durch die Erfindung wird ferner eine Vorrichtung vorgeschlagen zum Beschichten eines Grundkörpers, der mindestens einen inneren Kanal aufweist, bei welcher das Beschichten mittels chemischer Abscheidung aus der Dampfphase erfolgt, welche Vorrichtung ein Reaktorgefäss mit einem Reaktionsraum aufweist, in dem eine Halteeinrichtung zur Aufnahme des Grundkörpers vorgesehen ist, wobei in dem Reaktorgefäss ein innerer Generator vorgesehen ist, welcher geeignet ist, die Reaktivität eines von einer externen Quelle zuführbaren Prozessgases mit Hilfe eines reaktivitätsändernden Materials zu erhöhen, und welcher einen Ausgang zum Einleiten des Prozessgases in den Reaktionsraum aufweist. Die Halteeinrichtung ist mit einem Auslass des Reaktorgefässes verbunden, und derart zur Aufnahme des Grundkörpers ausgestaltet ist, dass das Prozessgas aus dem Reaktionsraum durch den mindestens einen inneren Kanal des Grundkörpers und die Halteeinrichtung zum Auslass strömen kann.

Diese Vorrichtung ist speziell für das erfindungsgemässe Verfahren geeignet, weil sie so ausgestaltet ist, dass das Prozessgas aus dem Reaktionsraum heraus durch den mindestens einen inneren Kanal abführbar ist.

Aus den gleichen Gründen wie sie bereits für das erfindungsgemässe Verfahren erläutert wurden, ist bei der Vorrichtung vorzugsweise für jeden inneren Kanal die Geometrie der Strömungsverbindung zwischen dem inneren Kanal und der Halteeinrichtung so ausgestaltet, dass eine vorgebbare Flussrate des Prozessgases durch den jeweiligen Kanal realisierbar ist.

In einer bevorzugten Ausgestaltung ist die Halteeinrichtung zur Aufnahme von mindestens einer Turbinenschaufel ausgestaltet

Durch die Erfindung wird ferner ein Grundkörper, insbesondere eine Turbinenschaufel, vorgeschlagen, der bzw. die mit einem erfindungsgemässen Verfahren oder mit einer erfindungsgemässen Vorrichtung beschichtet ist.

Weitere vorteilhafte Massnahmen und bevorzugte Verfahrensführungen ergeben sich aus den abhängigen Ansprüchen.

Im Folgenden wird die Erfindung sowohl in apparativer als auch in verfahrenstechnischer Hinsicht anhand von Ausführungsbeispielen und anhand der Zeichnung näher erläutert, In der schematischen Zeichnung zeigen:
- Fig. 1:: eine schematische Darstelllung wesentlicher Teile eines Ausführungsbeispiels einer erfindungsgemässen Vorrichtung, die zur Durchführung eines erfindungsgemässen Verfahrens geeignet ist, und
- Fig. 2:: Darstellung einer Turbinenschaufel mit inneren Kanälen, die von der Halteeinrichtung aufgenommen wird.

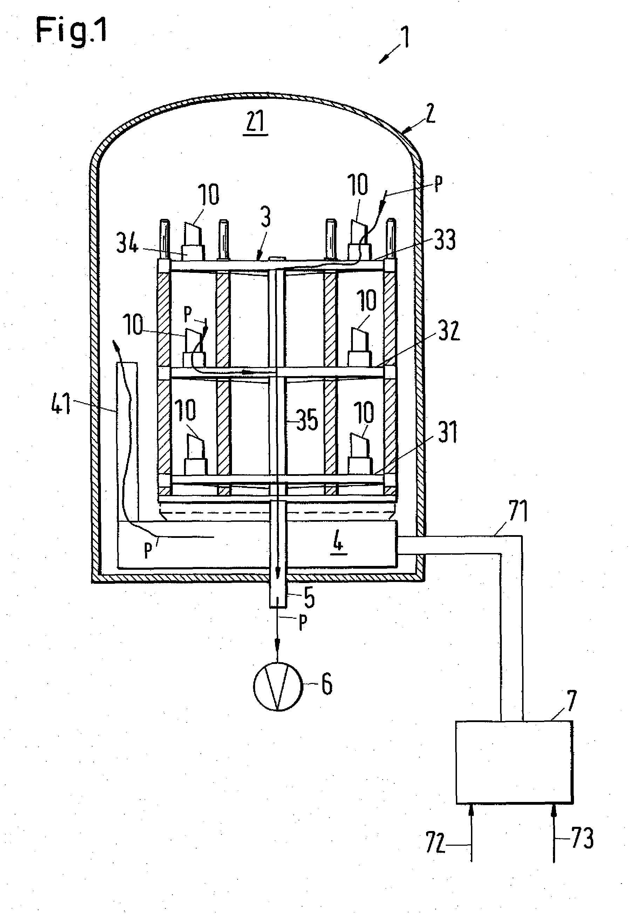

Durch die Erfindung wird ein Verfahren und eine Vorrichtung vorgeschlagen zum Beschichten eines Grundkörpers 10 (Fig. 1), der mindestens einen inneren Kanal aufweist. Das Beschichten erfolgt mittels chemischer Abscheidung aus der Dampfphase (Chemical vapor deposition; CVP) unter Verwendung eines Prozessgases. CVP an sich ist ein hinlänglich bekannter Prozess, dessen Details daher hier nicht näher erläutert werden. Prinzipiell ist das erfindungsgemässe Verfahren für alle Beschichtungen geeignet, die mittels CVP herstellbar sind, insbesondere für metallische Beschichtungen. Durch das erfindungsgemässe Verfahren wird es ermöglicht, innere Oberflächen und innere Kanäle auch sehr komplexer Strukturen gleichmässig mit einer vorgebbaren Dicke zu beschichten.

Im Folgenden wird mit beispielhaftem Charakter darauf Bezug genommen, dass der zu beschichtende Grundkörper 10 eine Turbinenschaufel einer Flugzeugturbine oder einer landgestützten industriellen Gasturbine ist. Ferner wird auf den für die Praxis besonders wichtigen Fall Bezug genommen, dass die äusseren und die inneren Oberflächen der Turbinenschaufel 10 alitiert (aluminisiert) werden sollen, das heisst, dass Aluminium chemisch aus der Dampfphase abgeschieden werden soll.

Fig. 1 zeigt in einer schematischen Darstellung ein Ausführungsbeispiel einer erfindungsgemässen Vorrichtung, die gesamthaft mit dem Bezugszeichen 1 bezeichnet ist. Die Vorrichtung 1 umfasst ein Reaktorgefäss 2 mit einem Reaktionsraum 21 in dem eine Halteeinrichtung 3 zur Aufnahme des Grundkörpers, hier mehrerer Turbinenschaufeln 10 angeordnet ist, Die Halteeinrichtung 3 umfasst üblicherweise mehrere, hier drei, Etagen 31, 32, 33, auf denen die Turbinenscilaufeln 10 verteilt sind.

In dem Reaktorgefäss 2 ist ferner ein interner Generator 4 vorgesehen, mit dem die Reaktivität des Prozessgases für den CVP-Prozess erhöht wird. Der interne Generator hat einen Ausgang 41, durch welchen das Prozessgas aus dem internen Generator 4 in den Reaktionsraum 21 eingeleitet wird. Ansonsten ist der Generator 4 gegenüber dem Reaktionsraum 21 abgedichtet.

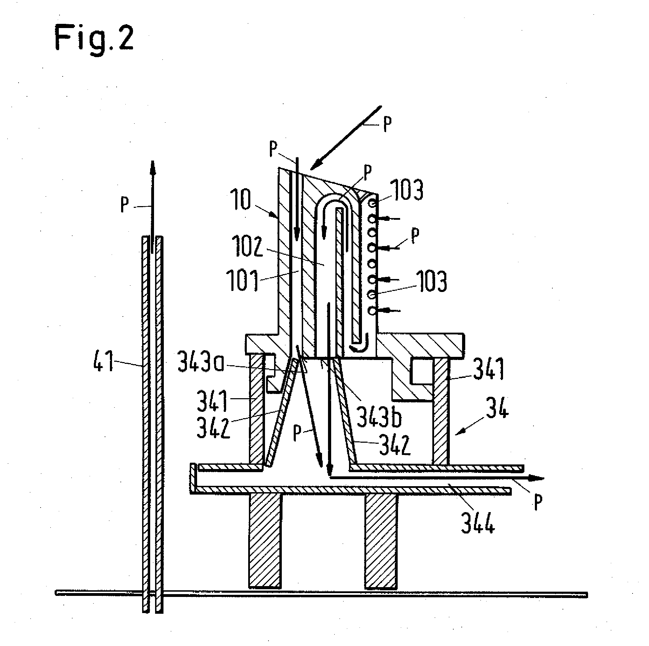

Die Halteeinrichtung 3 dient gleichzeitig zum Abführen des Prozessgases und ist als Gassammelsystem ausgestaltet Für jede Turbinenschaufel 10 weist die Halteeinrichtung 3 einen Halter 34 (Fig. 2) auf, der in Fig. 2 detaillierter dargestellt ist.

Bei dem in Fig. 2 dargestellten Ausführungsbeispiel hat die Turbinenschaufel 10 zwei innere Kanäle 101, 102, durch die im Betriebszustand Kühlluft strömt. Der innere Kanal 101 erstreckt sich im Wesentlichen geradlinig entlang der Eintrittskante der Turbinenschaufel 10. Der innere Kanal 102 erstreckt sich gewunden von der Austrittskante durch das Innere der Turbinenschaufel 10. An der Austrittskante sind mehrere Kühlluftbohrungen 103 vorgesehen, die in den Kanal 102 münden. Im Betriebszustand der Turbine strömt die Kühlluft durch den Kanal 102 und tritt durch die Kühlluftbohrungen 103 aus.

Der Halter 34 für die Turbinenschaufel 10 hat mehrere Funktionen. Zum einen fixiert der Halter 34 mittels eines an die jeweilige Schaufel 10 angepassten Flansches 341 die Turbinenschaufel 10, wobei dieser Flansch 341 gleichzeitig dazu dient, Bereiche des Grundkörpers, die nicht beschichtet werden sollen, abzudecken, wie hier den Turbinenschaufelfuss. Der Halter 34 weist ferner in seinem Inneren eine Gaspassage 344 auf, durch die das Prozessgas strömen kann. Zudem sind in dem Halter 34 Leitelemente 342 angeordnet, die mit den dem Halter 34 zugewandten Enden der inneren Kanäle 101,102 derart zusammenwirken, dass sie Strömungsverbindungen 343a und 343b zwischen den inneren Kanälen 101, 102 und der Halteeinrichtung 3 bilden, sodass das Prozessgas aus den inneren Kanälen 101, 102 in die Gaspassage 344 strömen kann.

Wie dies Fig. 1 zeigt, vereinigen sich die Gaspassagen 344 in einer gemeinsamen Leitung 35 der Halteeinrichtung 3. Diese Leitung 35 führt zu einem Auslass 5 am Boden des Reaktorgefässes 2, der mit einer Pumpe 6 verbunden ist. Die Pumpe 6 ist beispielsweise eine Flüssikeitsringpumpe oder eine mechanische Vakuumpumpe. Die Halteeinrichtung 3 als Gassammelsystem auszugestalten, ermöglicht eine äusserst kompakte und platzsparende Ausgestaltung der erfindungsgemässen Vorrichtung 1.

Andere an sich bekannte Komponenten des Reaktorgefässes 2 wie beispielsweise Heizeinrichtungen, Einlässe und Auslässe zum Spülen des Reaktionsraums z. B. mit Argon usw. sind aus der CVD-Technik hinlänglich bekannt und werden daher hier nicht näher erläutert

Wie dies Fig. 1 zeigt, ist ferner eine externe Quelle 7 für das Prozessgas vorgesehen, die über eine Zuführleitung 71 mit dem internen Generator 4 im Innern des Reaktorgefässes verbunden ist. Der externen Quelle 7 werden die Ausgangsstoffe zugeführt- angedeutet durch die Pfeile 72 und 73 -, aus denen das Prozessgas generiert wird. Die Quelle 7 kann ein konventioneller Generator zur Erzeugung eines Metallhalogenids sein.

Im Falle der Alitierung wird in der externen Quelle 7 vorzugsweise ein aluminiumhalogenidhaltiges Prozessgas generiert, beispielsweise Aluminiumtrichlorid AlCl₃ oder Aluminiunmtrifluorid AlF₃. Dies kann in an sich bekannter Weise erfolgen, indem Aluminium erhitzt wird und dann das entsprechende Halogenidsäuregas über das erhitzte Aluminium geleitet wird, Im vorliegenden Falle wird der Quelle 7 Salzsäuregas HCl über die Zuführung 72 zugeführt, um so AICI₃ zu generieren. Über die Zuführung 73 kann zusätzlich noch ein Trägergas eingeleitet werden, üblicherweise ein reduzierendes Gas wie Wasserstoff H₂ und/oder ein Inertgas wie Argon Ar₂. Dieses Trägergas bildet dann zusammen mit dem AICI₃ das Prozessgas, welches über die Zuführleitung 71 in den internen Generator 4 im Innern des Reaktorgefässes 2 eingeleitet wird.

Die Aufgabe des inneren Generators 4 ist es, die Reaktivität des Prozessgases mit Hilfe eines reaktivitätsändernden Materials zu erhöhen, um so eine bessere Abscheidung des Metalls auf den zu beschichtenden Flächen zu erzielen. Im vorliegenden Fall wird ein erheblicher Teil des Aluminiurntrichlorids im Prozessgas in die aluminiumreichere und reaktivere Phase des Aluminiummonochlorids AICI umgewandelt. Da AICI deutlich instabiler ist als AlCl₃ ist es besonders vorteilhaft, dass die aluminiumreichere Phase AICI erst im Inneren des Reaktorgefässes 2 erzeugt wird. Das Prozessgas, das nun einen hohen Anteil an AlCl aufweist wird dann aus dem inneren Generator 4 über dessen Ausgang 41 in den Reaktionsraum 21 eingeleitet.

Die Erhöhung der Reaktivität des Prozessgases durch Generierung des aluminiumreichen Aluminiummonochlorids im inneren Generator 4 erfolgt, indem das aus der externen Quelle kommende Prozessgas, welches das AlCl₃ enthält, über oder durch erhitztes, aluminiumhaltiges Material geführt wird.

Eine Möglichkeit besteht darin, im Inneren Generator 4 einen oder mehrere Behälter mit Chrom-Aluminium (CrAl-) Chips vorzusehen, die zunächst auf eine für die gewünschte Reaktion günstige Temperatur erhitzt werden. Über oder durch diese CrAl-Chips wird dann das Prozessgas zur Erhöhung seiner Reaktivität geleitet. Natürlich sind auch andere Aluminiumlegierungen geeignet, um die Reaktivität des Prozessgases zu erhöhen.

Gemäss einer besonders bevorzugten Verfahrensführung ist in dem inneren Generator 4 flüssiges Metall, hier also flüssiges Aluminium vorgesehen, um die Reaktivität des Prozessgases zu erhöhen, Das Aluminium wird in elementarer Form in einem oder mehreren Behältern bis über den Schmelzpunkt erhitzt, sodass es in der flüssigen Phase vorliegt. Über dieses flüssige Aluminium wird dann das aus der externen Quelle 7 kommende Prozessgas geleitet. Dazu wird das Prozessgas vorzugsweise in einer schlangenförmigen oder mäandierenden Bahn durch den internen Generator 4 geführt, um eine möglichst intensive Aufnahme von Aluminium durch das Prozessgas zu realisieren. Es hat sich gezeigt, dass sich mit flüssigem Aluminium als reaktivitätsändernden Material ein besonders hoher Anteil von AICI im Prozessgas und damit für die gewünschte Abscheidung eine besonders günstige Voraussetzung generieren lässt. Um ungewünschte Reaktionen des flüssigen Aluminiums im inneren Generator zu vermeiden, werden die Behälter für das flüssige Aluminium vorzugsweise aus Graphit angefertigt.

Im Folgenden wird nun ein Ausführungsbeispiel des erfindungsgemässen Verfahrens erläutert. Zunächst werden die zu beschichtenden Grundkörper - hier also die Turbinenschaufehl 10 - in die an sie angepassten Halter 34 der Halteeinrichtung 3 eingesetzt. Dann wird das Reaktorgefäss verschlossen und ein- oder mehrmals mit einem Inertgas, beispielsweise Argon, gespült, insbesondere, um störende Luft- oder Sauerstoffreste zu entfernen, die bei der Beschichtung zu ungewünschten Oxidationen führen könnten. Es hat sich als vorteilhaft erwiesen, den Reaktionsraum 21 mindestens einmal zusätzlich mit Helium zu spülen, um Luftblasen, die sich insbesondere im oberen Bereich des Reaktionsraums 21 halten können, sicher zu entfernen.

Die zu beschichtenden Turbinenschaufeln werden auf eine für die Reaktion günstige Temperatur aufgeheizt. In der externen Quelle 7 wird das Prozessgas generiert und dem inneren Generator 4 zugeführt. Dort wird die Reaktivität des Prozessgases mittels flüssigem Aluminium erhöht, wobei im Prozessgas ein erheblicher Anteil an Aluminiummonochlorid Alcl generiert wird. Dieses Prozessgas wird über den Ausgang 41 in den Reaktionsraum 21 eingeleitet, wo es sich verteilt und die Beschichtung der äusseren Oberflächen der Turbinenschaufeln 10 beginnt.

Mittels der Pumpe 6 wird das Prozessgas aus dem Reaktionsraum 21 durch die Kühlluftbohrungen 103 (Fig. 2) und durch die inneren Kanäle 101, 102 abgesaugt. Dabei erfolgt die Beschichtung der inneren Oberflächen und der inneren Kanäle 101, 102 der Turbinenschaufeln 10. Schliesslich gelangt das Prozessgas über die Gaspassagen 344 und die gemeinsame Leitung 35 und den üblicherweise beheizten Auslass 5 in nicht dargestellte Kühlfallen und von dort in ebenfalls nicht dargestellte Neutralisierungsbehälter,

Die Strömung des Prozessgases ist in den Fig. 1 und 2 durch die mit dem Bezugszeichen P bezeichneten Pfeile illustriert.

Der Beschichtungsvorgang wird bei diesem Ausführungsbeispiel bei einem Druck zwischen etwa 100 mbar und 1 bar durchgeführt. Das Prozessgas wird auf über 1000°C beispielsweise 1080°C aufgeheizt.

Besonders vorteilhaft ist es, die Flussrate des Prozessgases und damit seine Verweilzeit in den inneren Kanälen 101, 102 durch die Geometrie der Strömungsverbindungen 343a, 343b zwischen den inneren Kanälen 101, 102 und dem Halter der Halteeinrichtung 3 zu kontrolliern. Somit lässt sich für jeden inneren Kanal die relative Flussrate des Prozessgases individuell einstellen. Da die verschiedenen inneren Kanäle 101, 102 oft sehr unterschiedliche Strömungswiderstände darstellen, beispielsweise durch ihre Länge, ihren Durchmesser oder ihre Krümmung bedingt, kann durch ein dementsprechendes Dimensionieren der Strömungsverbindungen 343a, 343b erreicht werden, dass sich die relativen Flussraten des Prozessgases so einstellen, dass in beiden inneren Kanälen 101, 102 eine im wesentlichen gleich dicke Beschichtung generiert wird,

Mit dieser Massnahme können auch systembedingte Besonderheiten berücksichtigt werden. So kann es vorkommen, dass tendenziell durch die untere Etage 31 der Halteeinrichtung 3 mehr Prozessgas abgesaugt wird als durch die obere Etage 33. Dies kann dann dadurch ausgegeben werden, dass der Strömungswiderstand in der unteren Etage 31 beispielsweise durch Drosselstellen im Vergleich zum Strömungswiderstand in der oberen Etage so erhöht wird, dass für entsprechende innere Kanäle von auf der unteren Etage 31 und auf der oberen Etage 33 angeordneten Turbinenschaufeln 10 im Wesentlichen die gleichen relativen Flussraten und damit Verweilzeiten des Prozessgases resultieren. Dies Anpassung des Strömungswiderstands kann sowohl individuell für jeden Halter 34 aber auch oder in Kombination mit einer Anpassung pro Etage 31,32,33 erfolgen,

Zur Kühlung der Turbinenscilaufeln 10 insbesondere von modernen Gasturbinen werden diese Turbinenschaufeln häufig mit sehr komplexen inneren Oberflächen ausgestaltet, die eine Vielzahl von Gasflusspfaden unterschiedlicher Geometrie aufweisen, beispielsweise Durchlässe, Kanäle, Kreisläufe oder Kammern, sodass stark unterschiedliche Gasfluss-Charakteristiken resultieren. Die Anforderungen, um alle diese inneren Oberflächen befriedigen zu beschichten, können sehr unterschiedlich sein. Die Gasfluss-Charakteristiken können experimentell und oder theoretisch analysiert werden, beispielsweise durch Bestimmung der Länge, der Fläche, des Volumens der zu beschichtenden Passage. In Abhängigkeit von der gewünschten Dicke der Beschichtung kann dann für jeden der inneren Kanäle die relative Prozessgas-Flussrate relativ zu den anderen inneren Kanälen ermittelt werden. Anhand solcher Untersuchungen können die Prozessgas-Flussraten für jeden inneren Kanal individuell so eingestellt werden, dass das gewünschte Volumen an Prozessgas durch diesen Kanal strömt. Die Feineinstellung kann ndann empirisch erfolgen.

Wie bereits erwähnt erfolgt die Einstellung der jeweiligen Flussraten durch die inneren Kanäle vorzugsweise dadurch, dass die Öffnungen in dem Halter 34 bzw. der Halteeinriciltung 3 so dimensioniert werden, dass die gewünschte relative Flussrate des prozessgases resultiert.

Natürlich ist es auch möglich, das erfindungsgemässe Verfahren durch eine entsprechende Einstellung der relativen Flussraten so durchzuführen, dass in vorgebbaren innerten Kanälen dickere oder dünnere Beschichtungen resultieren als in den anderen inneren Kanälen.

Durch die Erfindung wird also ein Verfahren und eine Vorrichtung vorgeschlagen, die insbesondere auch die Beschichtung innerer Oberflächen von hohlen Grundkörpern ermöglichen, die mindestens einen inneren Kanal aufweisen. Dazu wird das Prozessgas in den Reaktionsraum 21 eingeleitet und dann aus dem Reaktionsraum 21 durch den zumindest einen inneren Kanal des Grundkörpers über eine Verbindung zum Auslass des Reaktorgefässes abgesaugt. Dadurch lässt sich eine gleichmässige Beschichtung vorgebbare Dicke auch auf den inneren Oberflächen erzielen.

## Patentansprüche

1. Verfahren zum Beschichten eines Grundkörpers, der mindestens einen inneren Kanal (101,102) aufweist, bei welchem Verfahren das Beschichten mittels chemischer Abscheidung aus der Dampfphase erfolgt, wobei der Grundkörper (10) auf einer Halteeinrichtung (3) in einem Reaktionsraum (21) eines Reaktorgefässes (2) angeordnet wird, wobei von einer externen Quelle (7) ein Prozessgas geliefert wird, das Prozessgas einem internen Generator (4) in dem Reaktionsgefäss (2) zugeführt wird, in welchem die Reaktivität des Prozessgases mit Hilfe eines reaktivitätsändernden Materials erhöht wird, und das Prozessgas aus dem internen Generator (4) in den Reaktionsraum (21) geleitet wird, **dadurch gekennzeichnet, dass** das Prozessgas aus dem Reaktionsraum (21) durch den mindestens einen inneren Kanal (101,102) und durch die Halteeinrichtung (3) zu einem Auslass (5) des Reaktorgefässes (2) gesaugt wird,

2. Verfahren nach Anspruch 1, bei welchem die Flussrate des Prozessgases durch jeden inneren Kanal (101,102) durch die Geometrie der Strömungsverbindung (343a,343b) zwischen dem inneren Kanal (101,102) und der Halteeinrichtung (3) kontrolliert wird.

3. Verfahren nach einem der vorangehenden Ansprüche, bei welchem der Reaktionsraum (21) vor dem Beschichten mindestens einmal mit Helium gefüllt und evakuiert wird.

4. Verfahren nach einem der vorangehenden Ansprüche, bei welchem das Beschichten ein Aluminiumbeschichten ist.

5. Verfahren nach einem der vorangehenden Ansprüche, wobei das reaktivitätsändernde Material flüssig ist und insbesondere flüssiges Aluminium ist.

6. Verfahren nach einem der vorangehenden Ansprüche, bei welchem der Grundkörper eine Turbinenschaufel (10) ist.

7. Vorrichtung zum Beschichten eines Grundkörpers, der mindestens einen inneren Kanal (101,102) aufweist, bei welcher das Beschichten mittels chemischer Abscheidung aus der Dampfphase erfolgt, welche Vorrichtung ein Reaktorgefäss (2) mit einem Reaktionsraum (21) aufweist, in dem eine Halteeinrichtung (3) zur Aufnahme des Grundkörpers (10) vorgesehen ist, wobei in dem Reaktorgefäss (2) ein innerer Generator (4) vorgesehen ist, welcher geeignet ist, die Reaktivität eines von einer externen Quelle (7) zuführbaren Prozessgases mit Hilfe eines reaktivitätsändernden Materials zu erhöhen, und welcher einen Ausgang (41) zum Einleiten des Prozessgases in den Reaktionsraum (21) aufweist, **dadurch gekennzeichnet, dass** die Halteeinrichtung (3) mit einem Auslass (5) des Reaktorgefässes (2) verbunden ist, und derart zur Aufnahme des Grundkörpers (10) ausgestaltet ist, dass das Prozessgas aus dem Reaktionsraum (21) durch den mindestens einen inneren Kanal (101,102) des Grundkörpers (10) und die Halteeinrichtung (3) zum Auslass (5) strömen kann.

8. Vorrichtung nach Anspruch 7, bei welcher für jeden inneren Kanal (101, 102) die Geometrie der Strömungsverbindung (343a,343b) zwischen dem inneren Kanal und der Halteeinrichtung so ausgestaltet ist, dass eine vorgebbare Flussrate des Prozessgases durch den jeweiligen Kanal (101,102) realisierbar ist.

9. Vorrichtung nach einem der Ansprüche 7-8 bei welchem die Halteeinrichtung (3) zur Aufnahme von mindestens einer Turbinenschaufel (10) ausgestaltet ist.

10. Grundkörper, insbesondere Turbinenschaufel, beschichtet mit einem Verfahren gemäss einem der Ansprüche 1-6 oder mit einer Vorrichtung gemäss einem der Ansprüche 7-9.
